# EUROPEAN PATENT APPLICATION

(11) **EP 1 791 175 A2**
(43) Date of publication of application: **30.05.2007**
(21) Application number: 06024368.0
(22) Date of filing: 24.11.2006
(51) Int. Cl.: H01L 21/762

(54) **Method of manufacturing bonded wafer**

(30) Priority: 24.11.2005 JP 2005338097
(71) Applicant: SUMCO Corporation, Tokyo 105-8634 (JP)
(72) Inventor: Nakamura, Shinya, Tokyo 105-8634 (JP); Morimoto, Nobuyuki, Tokyo 105-8634 (JP)
(74) Representative: polypatent

(57) **Abstract**

The method of manufacturing a bonded wafer including, implanting hydrogen ions, rare gas ions, or a mixture of hydrogen ions and rare gas ions into a bond wafer to form an ion implantation layer in the bond wafer, bonding the bond wafer in which the ion implantation layer has been formed to a base wafer to form a bonded wafer, and subjecting the bonded wafer to heat treatment to separate the bond wafer from the base wafer at the ion implantation layer as boundary to form the bonded wafer. In the method of manufacturing a bonded wafer, the heat treatment at least from the start of the separation to the end of the separation is conducted in an oxidizing atmosphere.

## Description

### BACKGROUND OF THE INVENTION

### FIELD OF THE INVENTION

This invention relates to a method for manufacturing a bonded wafer using the ion implantation separation method.

### DISCUSSION OF THE BACKGROUND

SOI (Silicon-On-Insulator) wafers afford such advantages over conventional silicon wafers as separation between elements, reduced parasitic capacitance between elements and substrate, and the ability to form three-dimensional configurations. Utilizing these advantages, SOI wafers have been employed in high-speed and low-power-consumption LSIs and the like in recent years.

In one method for manufacturing SOI wafers, known as the ion implantation separation method (also known as the "Smart Cut Method," a registered trademark) (see Japanese Unexamined Patent Publication (KOKAI) Heisei No. 5-211128, or English language family member U.S. Patent No. 5,374,564), hydrogen ions are implanted in the surface of a silicon wafer, after which heat treatment is conducted for separation at an ion implantation layer as boundary.

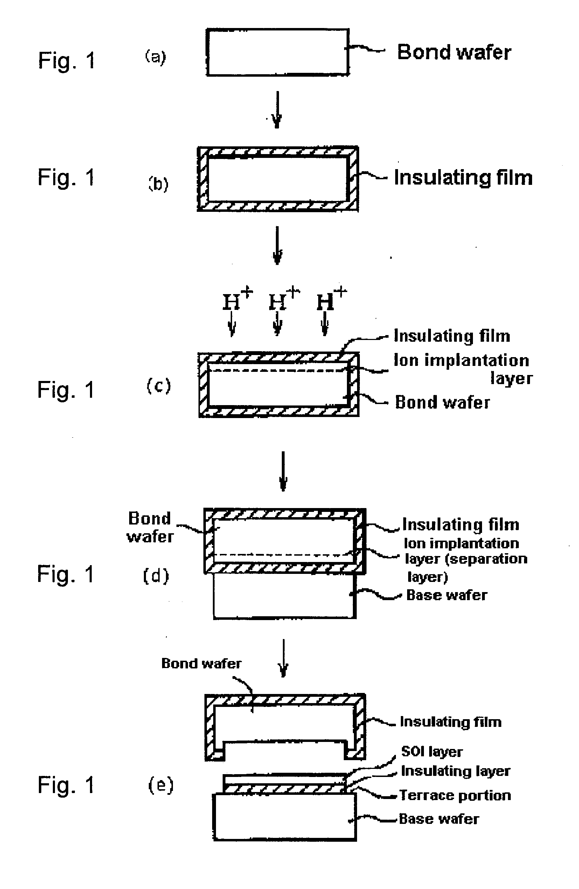

The steps of manufacturing an SOI wafer by the ion implantation separation method will be described based on Fig. 1.
First, an insulating film (such as an oxide film) is formed on a bond wafer (Fig. 1 (a), (b)).
Next, ions (such as hydrogen ions) are implanted in the bond wafer on which the insulating film has been formed, thereby forming an ion implantation layer in the wafer (Fig. 1 (c)).
The bond wafer in which ions have been implanted is then bonded to a base wafer (Fig. 1 (d)).
The bonded wafer is then heat treated, causing separation at the ion implantation layer. This forms an SOI layer on the insulating layer, yielding an SOI wafer (Fig. 1(e)).

The SOI layer surface thus obtained then serves as a region for device formation. However, there are problems in that in the ion implantation separation method, particles produced during separation adhere to the surface of the SOI layer, causing contamination and compromising the quality of the device.

Normally, since the bond wafer and the base wafer do not completely bond along the perimeter of the bonding interface, a portion (terrace portion) of the surface of the base wafer is exposed along the perimeter of the separation surface (Fig. 1(e)). Particles on such terrace portion are subjected to pressure by both wafers and are heated during the heat treatment, causing them to adhere firmly. Thus, they are difficult to remove by ordinary cleaning particularly in batch-type cleaning units. In cases where a heat treatment is conducted in the next step to remove damaged layers and the like, particles on the surfaces of the terrace portion that have not been removed by cleaning scatter onto the surface of the SOI layer, adhere, and compromise quality.

Accordingly, brush washing with a single-wafer cleaning unit, dual-fluid cleaning, and the like could conceivably be used to enhance removal of particles. However, such highly efficient cleaning reduces throughput and decreases productivity.

### SUMMARY OF THE INVENTION

A feature of the present invention provides for obtaining a high-quality bonded wafer by preventing contamination due to particles.

A feature of the present invention relates to a method of manufacturing a bonded wafer including implanting hydrogen ions, rare gas ions, or a mixture of hydrogen ions and rare gas ions into a bond wafer to form an ion implantation layer in the bond wafer, bonding the bond wafer in which the ion implantation layer has been formed to a base wafer to form a bonded wafer, and subjecting the bonded wafer to heat treatment to separate the bond wafer from the base wafer at the ion implantation layer as boundary to form the bonded wafer, wherein the heat treatment at least from the start of the separation to the end of the separation is conducted in an oxidizing atmosphere.

According to the present invention, it becomes easy to remove particles generated during separation on the surface of wafers, particularly particles on the terrace by ordinary SC-1 cleaning (Standard Clean 1 - typically a mixture of NH₄OH, H₂O₂, and deionized water in an approximate ratio of 1:1:5, however other ratios are contemplated by the present invention), thereby providing a high-quality SOI wafer.

Other exemplary embodiments and advantages of the present invention may be ascertained by reviewing the present disclosure and the accompanying drawings.

### BRIEF DESCRIPTION OF THE DRAWINGS

The present invention will be described in the following text by the exemplary, non-limiting embodiments shown in the figures, wherein:
Figs. 1 (a) to (e) are drawings descriptive of the steps of manufacturing an SOI wafer by ion implantation separation method.
Fig. 2(a) shows microscope photographs of a sample separation treated in a nitrogen atmosphere, both immediately following separation and after SC-1 cleaning.
Fig. 2(b) shows a microscope photograph following SC-1 cleaning of a sample that was separation treated in an approximately 100 percent oxygen atmosphere after being heated to approximately 450 degree Celsius.
Fig. 2(c) shows a microscope photograph following SC-1 cleaning of a sample that was subjected to a separation step in an approximately 100 percent oxygen atmosphere.

### DESCRIPTIONS OF THE EMBODIMENTS

The following preferred specific embodiments are, therefore, to be construed as merely illustrative, and not limitative of the remainder of the disclosure in any way whatsoever. In this regard, no attempt is made to show structural details of the present invention in more detail than is necessary for the fundamental understanding of the present invention, the description taken with the drawings making apparent to those skilled in the art how the several forms of the present invention may be embodied in practice.

The method of manufacturing a bonded wafer of the present invention includes implanting hydrogen ions, rare gas ions, or a mixture of hydrogen ions and rare gas ions into a bond wafer to form an ion implantation layer in the bond wafer, bonding the bond wafer in which the ion implantation layer has been formed to a base wafer to form a bonded wafer, and subjecting the bonded wafer to heat treatment to separate the bond wafer from the base wafer at the ion implantation layer as boundary to form the bonded wafer, wherein the heat treatment at least from the start of the separation to the end of the separation is conducted in an oxidizing atmosphere.

In the ordinary ion implantation separation method, the separation by heat treatment is conducted in an inert atmosphere. By contrast, in the present invention, the heat treatment at least from the start of separation to the end of separation is conducted in an oxidizing atmosphere. When separation is conducted in an oxidizing atmosphere in this manner, an oxide film forms on the separation surface. Particles adhering through this oxide film can be readily removed by ordinary SC-1 cleaning.

### ION IMPLANTATION

The wafer employed in the present invention will be described first.

In the present invention, a bond wafer and a base wafer are bonded to produce a bonded wafer. Single crystal silicon wafers may be employed as the bond wafer and the base wafer. The thickness of the bond wafer and base wafer is not specifically limited; however, wafers having a thickness of approximately 750 to approximately 800 micrometers are generally employed.

When manufacturing an SOI wafer, an oxide film is formed as an insulating film on the surface of the bond wafer. The oxide film need only be formed on the surface bonding with the base wafer, but it is also possible to cover the entire surface of the bond wafer with oxide film. The thickness of the oxide film can be suitably determined based on the application and is not specifically limited. However, the oxide film having a thickness of equal to or less than approximately 200 nm is generally employed. Further, the oxide film can be formed by known methods such as thermal oxidation and CVD.

Hydrogen ions, rare gas ions, or a mixture of hydrogen ions and rare gas ions, with hydrogen ions being preferred, is employed for implantation into the bond wafer. The depth to which the ions are implanted varies with the implantation conditions, but can be from approximately 0.2 to approximately 1 micrometer, for example.

A known ion implantation device may be employed. The acceleration voltage during ion implantation may be from approximately 10 to approximately 100 keV, for example.

A low level of ion implantation is desirable from the perspective of productivity. However, an excessively low level may render the subsequent separation by heat treatment difficult. Taking this into account, the ion implantation dose level may be from approximately 2 e¹⁶ to approximately 1 e¹⁷/cm², for example, with from approximately 5 e¹⁶ to approximately 1 e¹⁷ /cm² being preferred.

### BONDING

The bond wafer, in which an ion implantation layer has been formed in the above ion implantation step, is then bonded to a base wafer. For example, it is possible to bond two wafers by contacting the surface of the bond wafer that has been ion implanted with a surface of the base wafer, for example, at room temperature. When the surface of the wafer serving as the contact surface during bonding is processed to a mirror finish, it is possible to adhere the two wafers without use of an adhesive or the like. If an insulating film has been formed on the bonding surface on the bond wafer side, the bond wafer and the base wafer can be bonded through the insulating film. Prior to bonding, the bonding surfaces are desirably RCA cleaned.

Prior to bonding, the bonding surfaces may be plasma treated with nitrogen, oxygen, helium, hydrogen, some other gas, or a mixture of gases to increase bonding strength.

### SEPARATION

Subjecting the bonded wafer obtained by the above bonding method to heat treatment separates the bond wafer at the ion implantation layer as a boundary. In the present invention, in the separation step, the heat treatment from at least the start of separation to the end of separation is conducted in an oxidizing atmosphere. Thus, an oxide film can be formed on the surface exposed by separation. Particles adhered to the separation surface through this oxide film adhere weakly and can be readily removed by ordinary SC-1 cleaning. In particular, when the bond wafer and the base wafer are not completely bonded along the perimeter portion of the bond boundary, as stated above, the surface of the bonded wafer that has become exposed by separation is comprised of a center portion (the surface of the SOI layer in Fig. 1(e)) and a peripheral portion (the terrace portion in Fig. 1(e)) surrounding the center portion. As shown in Fig. 1(e), this center portion is different from the peripheral portion in level, and at least a portion of the peripheral portion is an exposure of at least a portion of the surface of the base wafer. As set forth above, particles on the terrace portion run the risk of contaminating the SOI layer surface serving as the device fabrication region. By contrast, when the heat treatment is conducted in an oxidizing atmosphere as set forth above, oxygen can enter these unbonded regions, forming an oxide film and preventing strong adhesion of particles to the terrace portion.

The temperature of the heat treatment in the separation step is generally equal to or more than approximately 300 degrees Celsius, preferably approximately 350 to approximately 500 degrees Celsius. When the temperature of the heat treatment is within this range, bubbles can be generated in the ion implantation layer. When these bubbles form a continuous layer, the separation can occur at the ion implantation layer as the boundary. Heat treatment can be conducted for from one minute to one hour, for example, with approximately 1 to approximately 30 minutes being preferred. The temperature can be increased at a rate of approximately 0.5 to approximately 10 degree Celsius/minute, for example, with approximately 1 to approximately 5 degree Celsius/minute being preferred. A known heat treatment device can be employed to implement the heat treatment.

In the present invention, in the separation step, at least the heat treatment from the start of separation to the end of separation is conducted in an oxidizing atmosphere. This heat treatment can be conducted at a temperature of approximately 400 to approximately 500 degrees Celsius. In the present invention, the heat treatment prior to the start of separation is also desirably conducted in an oxidizing atmosphere, it being highly desirable for the entire separation step to be conducted in an oxidizing atmosphere. Thus, an oxide film is reliably formed, making it possible to effectively prevent strong adhesion of particles.

The aforementioned oxidizing atmosphere is an atmosphere containing a level of oxygen capable of forming an oxide film on the wafer surface. The concentration of oxygen in the oxidizing atmosphere is, for example, approximately 10 to approximately 100 volume percent, preferably approximately 50 to approximately 100 volume percent. Gases that can be mixed with the oxygen are not specifically limited; for example, nitrogen (N₂), argon (Ar), and helium (He) can be employed, or any other gas in combination with oxygen capable of supplying oxygen in an amount sufficient to form an oxidizing atmosphere.

Following the heat treatment, cooling can be conducted by dropping the temperature to a prescribed level, thereby yielding a bonded wafer. This temperature reduction cooling step does not necessarily have to be conducted in an oxidizing atmosphere. However, it can be conducted with the wafer as is, without removing the wafer following separation step from the device (an oxidizing atmosphere) in which separation step has been conducted.

Even when particles adhere to the surface exposed by separation on the bonded wafer obtained in the above steps, they adhere through an oxide film and thus only adhere weakly. They can thus be readily removed by ordinary SC-I cleaning. Usually, even particles that would normally adhere strongly to the terrace portion and be difficult to remove can be readily removed. Thus, the present invention can prevent contamination of the bonded wafer surface (in SOI wafers in particular, the SOI layer surface serving as the device fabrication region), providing a high-quality, bonded wafer.

### EXAMPLES

The present invention will be described in detail below based on examples. However, the present invention is not limited to the examples.

Two 300 mm silicon wafers were obtained. One of the wafers was subjected to a thermal oxidation, forming an oxide film approximately 1,500 Angstroms thick on the surface thereof. Next, the wafer was subjected to hydrogen ion implantation (acceleration voltage approximately 50 keV, ion implantation dose level approximately 1 e¹⁷/cm²) and bonded to the other wafer to form a bonded wafer.

Subsequently, the bonded wafer was heated from approximately 350 degrees Celsius to approximately 500 degree Celsius and maintained at approximately 500 degree Celsius for approximately 30 minutes in the various atmospheres shown in Table 1. The wafer was then cooled to approximately 350 degrees Celsius and removed. Under these conditions, separation was begun at a temperature exceeding approximately 450 degree Celsius but not more than approximately 500 degree Celsius and the bond wafer was separated at the ion implantation layer as a boundary.

The surface of the wafer following separation (which had been exposed by separation) was SC-1 cleaned, and the number of particles on the terrace following SC-1 cleaning was measured with an optical microscope.

**Table 1**

| (Unit: Volume%) | | | | | | | |
|---|---|---|---|---|---|---|---|
| | Nitrogen atmosphere (Oxygen: 0%) | Oxygen concentration (mixed gas: nitrogen) | | | | | |
| | | 5% | 10% | 25% | 50% | 75% | 100% |
| Atmosphere at equal to or more than 350 degree Celsius (through separation process) | | △ | ○ | ○ | ○ | ○ | ○ |
| Atmosphere at equal to or more than 400 degree Celsius (in ramp up step) | × | △ | ○ | ○ | ○ | ○ | ○ |
| Atmosphere at equal to or more than 450 degree Celsius (in ramp up step) | | △ | △ | △ | △ | △ | △ |
| Atmosphere at equal to or more than 500 degree Celsius (during keeping step) | | × | × | × | × | × | × |

| | | | | | | | |
|---|---|---|---|---|---|---|---|
| In Table 1, "○" means that particles could be completely removed by SC-1 cleaning, "△" means that less than 100 particles remained per 1cm² on the terrace layer after SC-1 cleaning, and "×" means that 100 particles or greater remained per 1 cm² on the terrace layer after SC-1 cleaning. | | | | | | | |

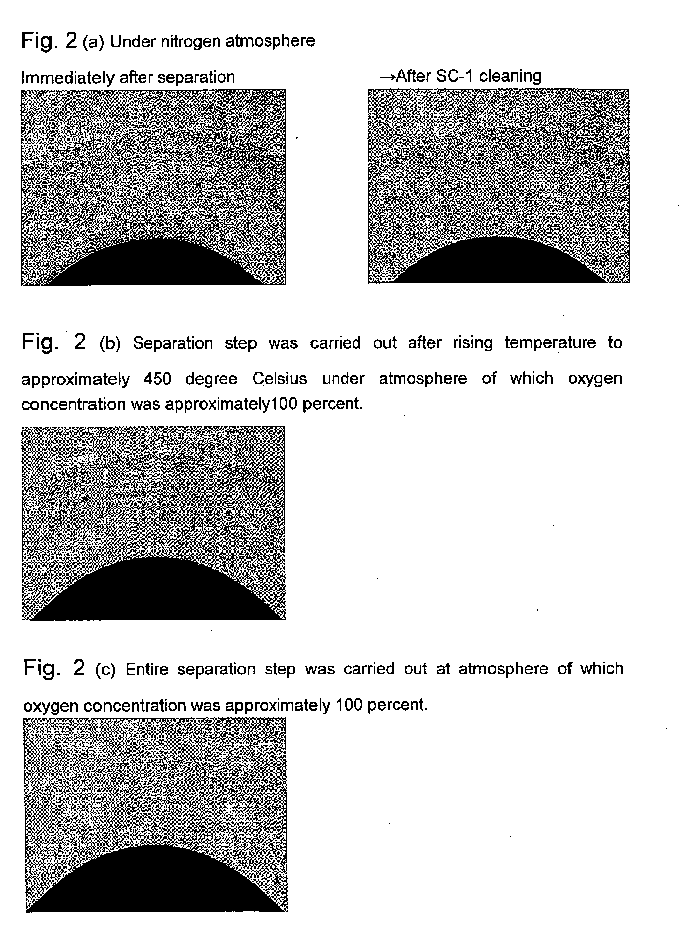

Figs. 2(a) to (c) shows microscope photographs of samples subjected to separation treatment under the nitrogen atmosphere shown in Table 1, both immediately following separation and following SC-I cleaning.

Evaluation Results
As shown in Table 1, when an oxidizing atmosphere with an oxygen concentration of 5 percent or more was employed as the atmosphere at least at the start of separation, particles on the terrace layer were readily removed by SC-1 cleaning.

By contrast, when the entire separation step was conducted in a nitrogen atmosphere and when just the keeping step following the start of separation was conducted in an oxidizing atmosphere, particles adhered strongly to the terrace layer and could not be removed by SC1 cleaning.

According to the present invention, high-quality SOI wafers can be provided.

Although the present invention has been described in considerable detail with regard to certain versions thereof, other versions are possible, and alterations, permutations and equivalents of the version shown will become apparent to those skilled in the art upon a reading of the specification and study of the drawings. Also, the various features of the versions herein can be combined in various ways to provide additional versions of the present invention. Furthermore, certain terminology has been used for the purposes of descriptive clarity, and not to limit the present invention. Therefore, any appended claims should not be limited to the description of the preferred versions contained herein and should include all such alterations, permutations, and equivalents as fall within the true spirit and scope of the present invention.

Having now fully described this invention, it will be understood to those of ordinary skill in the art that the methods of the present invention can be carried out with a wide and equivalent range of conditions, formulations, and other parameters without departing from the scope of the invention or any embodiments thereof.

## Claims

1. A method of manufacturing a bonded wafer comprising:
implanting hydrogen ions, rare gas ions, or a mixture of hydrogen ions and rare gas ions into a bond wafer to form an ion implantation layer in the bond wafer;
bonding the bond wafer in which the ion implantation layer has been formed to a base wafer to form a bonded wafer; and
subjecting the bonded wafer to heat treatment to separate the bond wafer from the base wafer at the ion implantation layer as boundary to form the bonded wafer, wherein
the heat treatment at least from the start of the separation to the end of the separation is conducted in an oxidizing atmosphere.

2. The method of manufacturing a bonded wafer of claim 1, wherein the oxidizing atmosphere has an oxygen concentration ranging from approximately 10 to approximately 100 volume percent.

3. The method of manufacturing a bonded wafer of claim 1 or 2, wherein the oxidizing atmosphere has an oxygen concentration ranging from approximately 50 to approximately 100 volume percent.

4. The method of manufacturing a bonded wafer of any of claims 1 to 3, wherein the heat treatment from the start of the separation to the end of the separation is conducted at a temperature ranging from approximately 400 to approximately 500 degrees Celsius.

5. The method of manufacturing a bonded wafer of any of claims 1 to 4, wherein
the bond wafer used in said implanting has an insulating film at least on a portion of the surface thereof, and in said bonding, the bond wafer is bonded to a base wafer through the insulating film.

6. The method of manufacturing a bonded wafer of claim 5, wherein the insulating film is an oxide film.

7. The method of manufacturing a bonded wafer of any of claims 1 to 6, wherein
the bonded wafer formed by heat treatment has a surface which has become exposed by said separation and is comprised of a center portion and a peripheral portion surrounding the center portion, and
the center portion is different from the peripheral portion in level.

8. The method of manufacturing a bonded wafer of claim 7, wherein at least a portion of the peripheral portion is an exposure of at least a portion of the surface of the base wafer.

9. The method of manufacturing a bonded wafer of any of claims 1 to 8, further comprising subjecting the bonded wafer to SC-1 cleaning to wash the surface which has been exposed by the separation.

10. The method of manufacturing a bonded wafer of any of claims 1 to 9, wherein the bonded wafer is a SOI wafer.
